(19) Europäisches Patentamt

European Patent Office

Office européen des brevets

(11) **EP 0 971 476 B1**

(12) **FASCICULE DE BREVET EUROPEEN**

(45) Date de publication et mention
de la délivrance du brevet:
**02.05.2003  Bulletin 2003/18**

(51) Int Cl.⁷: **H03B 5/12**, H03B 27/00

(21) Numéro de dépôt: **99401682.2**

(22) Date de dépôt: **06.07.1999**

(54) **Oscillateur présentant deux sorties en quadrature**

Oszillator mit zwei Quadraturausgängen

Oscillator with two quadrature outputs

(84) Etats contractants désignés:
**DE FR GB IT**

(30) Priorité:  **08.07.1998  FR 9808751**

(43) Date de publication de la demande:
**12.01.2000   Bulletin 2000/02**

(73) Titulaire: **STMicroelectronics S.A.**
**92120 Montrouge (FR)**

(72) Inventeur: **Lemaire, Frédéric**
**38120 Saint-Egrève (FR)**

(74) Mandataire: **Ilgart, Jean-Christophe**
**BREVALEX**
**3, rue du Docteur Lancereaux**
**75008 Paris (FR)**

(56) Documents cités:
**GB-A- 2 009 547        US-A- 5 561 399**

## Description

## Domaine technique

La présente invention concerne un oscillateur utilisant des circuits résonnants et présentant deux sorties déphasées de 90 degrés.

## Etat de la technique antérieure

Il est connu d'utiliser un oscillateur présentant deux sorties en quadrature dans certains types de récepteurs où, associé à deux mélangeurs de fréquence, il permet d'améliorer la réjection de la fréquence image. Il permet aussi de fournir des signaux en phase et en quadrature de phase de récepteurs "numériques". Il permet encore de réaliser un récepteur à fréquence intermédiaire nulle. Pour être performants, ces récepteurs doivent disposer de signaux fournis par l'oscillateur, ces signaux étant précisément déphasés de 90°. Par ailleurs, la pureté spectrale de ces oscillateurs doit être grande (bruit de phase très bas). Ceci est obtenu grâce à un coefficient de qualité du circuit résonnant élevé.

Il existe plusieurs solutions pour obtenir des signaux en quadrature de phase. On peut utiliser deux circuits RC, l'un des circuits déphasant le signal issu d'un oscillateur de + 45 degrés et l'autre circuit déphasant ce signal de - 45 degrés. L'inconvénient de cette solution est que, si le déphasage entre les deux voies est bien de 90 degrés dans une plage de fréquence étendue, il n'en est pas de même pour l'amplitude des signaux qui doit être ajustée en fonction de la fréquence de travail ou des dispersions liées aux valeurs des composants R et C.

On peut aussi utiliser un oscillateur à fréquence double à deux sorties déphasées de 180 degrés, suivi d'un diviseur de fréquence par 2, de type "compteur Johnson" fournissant deux signaux de sortie déphasés de 90 degrés. L'inconvénient de cette solution est qu'il faut réaliser un oscillateur à fréquence double, ce qui peut être très difficile en haute fréquence, et que cet oscillateur doit présenter un rapport cyclique de 0,5 très précisément.

On peut encore utiliser un oscillateur comportant quatre cellules identiques rebouclées, chaque cellule introduisant un déphasage de 90 degrés (ou deux cellules différentielles qui permettent d'obtenir un déphasage de 180 degrés "câblé"). La précision du déphasage entre deux cellules dans ce type d'oscillateur ne dépend que de l'appairage des cellules. En effet, par principe, la fréquence d'oscillation est la fréquence pour laquelle le déphasage en boucle ouverte est 0 ou 360 degrés. L'oscillateur étant composé de quatre cellules rigoureusement identiques, le déphasage entre chaque cellule est 360/4 = 90 degrés.

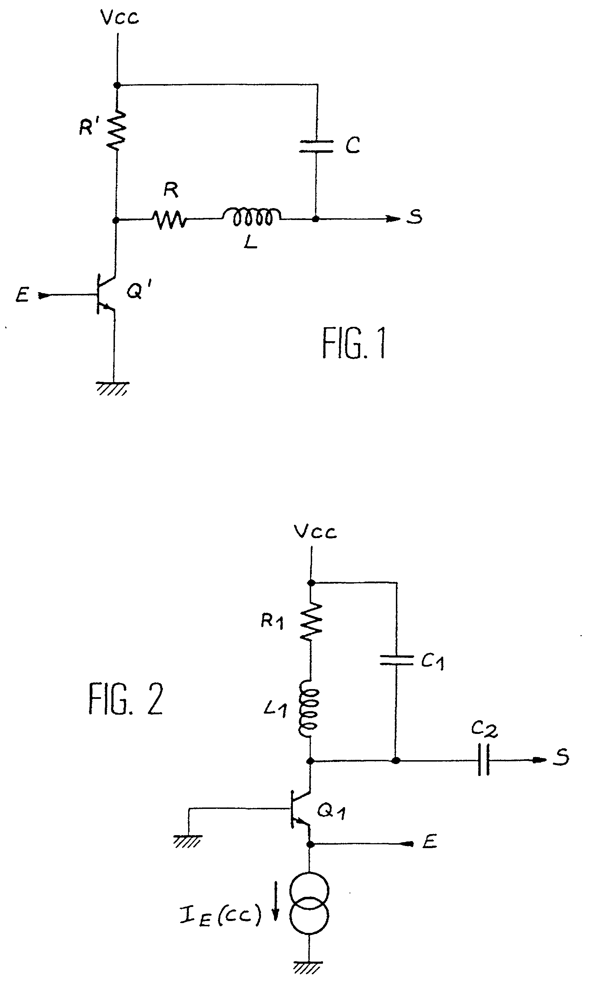

La figure 1 représente l'une des cellules d'un tel oscillateur selon l'art connu. Cette cellule passe-bas est utilisée, dans sa forme différentielle, dans l'article "1 GHz Quadrature Sinusoidal Oscillator" de R. DUNCAN et al., IEEE CICC 95. La cellule de base comporte un transistor Q' monté en émetteur commun. Le collecteur du transistor est relié à la tension continue d'alimentation $V_{cc}$ par une résistance R'.

La nécessité d'obtenir un bruit de phase bas implique l'utilisation de composants réactifs L et C ayant un coefficient de surtension Q le plus élevé possible, les oscillateurs RC étant trop bruyants.

La cellule de base représentée à la figure 1 permet d'obtenir un gain supérieur à l'unité et un déphasage de 90 degrés tout en présentant un coefficient de surtension Q maximum.

L'inductance L et la capacité C, montées en série, sont branchées en parallèle sur la résistance de collecteur R'. La résistance R représente les pertes de l'inductance L. L'entrée E de la cellule se fait sur la base du transistor Q'. La sortie S de la cellule forme le point commun entre l'inductance L et la capacité C.

La cellule représentée à la figure 1 présente, à la fréquence de résonance (soit à la pulsation de résonance $\omega_o$), un déphasage de 90 degrés et un coefficient de qualité en charge $Q_c$ tel que :

$$Q_c = \frac{L \cdot \omega_o}{R + R'}$$

le transistor et la capacité étant supposés parfaits.

L'augmentation du coefficient de qualité en charge $Q_c$, pour une inductance donnée, ne peut se faire qu'en diminuant R'.

Le gain G de la cellule est donné par la relation :

$$G = g_m \frac{R'}{R'+R) \, C \, \omega_o}$$

$g_m$ étant la transconductance du transistor.

Le gain G doit être supérieur à l'unité pour que l'oscillateur, composé de quatre cellules identiques en cascade (la sortie S d'une cellule étant reliée à l'entrée E de la cellule suivante et la sortie de la quatrième cellule étant reliée à l'entrée de la première cellule de la cascade), puisse fonctionner.

A titre d'exemple, les ordres de grandeur de la valeur des composants peuvent être les suivants. Si on choisit une inductance L de 5 nH, une valeur du coefficient de qualité de l'inductance seule $Q_s = L\omega_o/R = 5$ à une fréquence de 2 GHz et si on tolère une dégradation du coefficient de qualité en charge de 10% ($Q_c = 0,9 \, Q_s$), on obtient :

$$R' = 1,26 \ \Omega.$$

D'où, pour un gain G > 1, une valeur de résistance d'entrée en base commune $r_{ib}$ (correspondant à $l/g_m$) valant 5,7 Ω. Ceci correspond à une valeur du courant collecteur $I_c$ de 4,4 mA.

Cette valeur relativement élevée du courant collecteur représente un inconvénient. En outre, une cellule de ce type nécessite au moins un étage de type émetteur suiveur pour que l'impédance d'entrée du transistor réel ne vienne pas dégrader le coefficient de qualité $Q_c$. De plus, la valeur obtenue pour la résistance R' (1,26 Ω) est peu réaliste, dans le cas d'une réalisation en circuit intégré, car proche des valeurs des résistances parasites du circuit.

Le document US-A-5 561 399 divulgue un oscillateur à multiples résonateurs mis en cascade et possédant une valeur élevée du coefficient Q. Chaque cellule est formée d'un amplificateur et d'un circuit LC. Les cellules sont disposées en cascade et l'ensemble est rebouclé sur lui-même. L'oscillateur résonne à une fréquence pour laquelle la rotation de phase totale dans la boucle est un multiple de 360°.

**Exposé de l'invention**

Pour remédier à ces problèmes, il est proposé, selon la présente invention, un oscillateur constitué de quatre cellules identiques déphasant de 90 degrés, le signal de sortie d'une cellule étant délivré à l'entrée de la cellule suivante avec rebouclage des cellules sur elles-mêmes, chaque cellule comportant un amplificateur de courant et un circuit résonnant parallèle inductance-capacité disposé de sorte que le courant de sortie d'une cellule soit une fraction du courant capacitif du circuit résonnant parallèle, assurant ainsi le déphasage de 90° entre les courants d'entrée et de sortie de la cellule. Par amplificateur de courant, on entend un circuit présentant une faible impédance d'entrée et une forte impédance de sortie. Il peut s'agir d'un transistor monté en base commune, le circuit résonnant parallèle étant disposé dans le circuit du collecteur du transistor.

Le couplage entre une cellule et la cellule suivante peut être un couplage capacitif. Ce couplage peut aussi être inductif. Dans ce cas, il peut être réalisé par une self de liaison ou par le secondaire d'un transformateur dont le primaire constitue l'inductance du circuit résonnant.

**Brève description des dessins**

L'invention sera mieux comprise et d'autres avantages et particularités apparaîtront à la lecture de la description qui va suivre, donnée à titre d'exemple non limitatif, accompagnée des figures annexées parmi lesquelles :

- la figure 1, déjà décrite, est un schéma en courant alternatif de l'une des quatre cellules d'un oscillateur selon l'art connu,
- la figure 2 est un schéma en courant alternatif de l'une des cellules d'un premier oscillateur selon la présente invention et qui comprend quatre cellules identiques,
- la figure 3 est un schéma en courant alternatif de l'une des cellules d'un deuxième oscillateur selon la présente invention et qui comprend quatre cellules identiques,
- la figure 4 est un schéma en courant alternatif de l'une des cellules d'un troisième oscillateur selon la présente invention et qui comprend quatre cellules identiques.

**Description détaillée d'un mode de réalisation de l'invention**

La figure 2 représente la cellule de base d'un premier oscillateur selon l'invention. Il s'agit d'une cellule travaillant en courant en entrée comme en sortie : la sortie S est chargée par l'entrée E de la cellule suivante dont l'impédance est faible puisqu'il s'agit d'un montage en base commune. $I_E(cc)$ représente le courant continu d'émetteur.

Le circuit résonnant comprend une inductance $L_1$ en parallèle avec une capacité $C_1$. La résistance $R_1$ représente les pertes de l'inductance $L_1$. La capacité $C_2$ assure la liaison, en courant alternatif, avec la cellule suivante.

A la fréquence de résonance (correspondant à $\omega_o^2 = 1/L_1[C_1+C_2]$), le déphasage est de 90 degrés entre le courant entrant par E et le courant sortant par S. Le coefficient de qualité en charge est :

$$Q_c = \frac{L\,\omega_o}{R_1 + r_{ib}\left(\dfrac{C_2}{C_1 + C_2}\right)^2}$$

$r_{ib}$ étant la résistance d'entrée du transistor $Q_1$ en base commune, le transistor et les capacités $C_1$ et $C_2$ étant supposés parfaits. L'augmentation du coefficient de qualité $Q_c$, pour une inductance donnée, ne peut se faire qu'en diminuant $r_{ib}$.

La condition d'oscillation : gain (courant de sortie/courant d'entrée) supérieur à 1 en boucle ouverte, se traduit pour un transistor idéal par : avec :

$$Q_s = \frac{L_1\omega_o}{R_1}$$

$$Q_2 = \frac{1}{r_{ib}C_2\omega_o}$$

En reprenant l'application numérique précédente pour la figure 1, c'est-à-dire :

$$Q_c = 0,9\ Q_s,$$

$L_1 = 5$ nH,

$Q_s = 5$ à une fréquence d'oscillation de 2 GHz,

la condition d'oscillation donne alors :

$$\frac{C_2}{C_1 + C_2} = 0,22$$

La résistance $r_{ib}$ vaut alors 29 Ω, ce qui correspond à un courant collecteur $I_c$ de 0,9 mA.

On voit qu'un gain en puissance consommée (courant $I_c$) dans un rapport de 4,9 est obtenu pour les mêmes conditions de coefficient de qualité $Q_c$.

Contrairement à la cellule de l'art connu représentée à la figure 1, qui nécessite en pratique un étage supplémentaire du type émetteur suiveur, la cellule de l'oscillateur selon l'invention est directement utilisable avec un transistor réel.

La figure 3 représente la cellule de base d'un deuxième oscillateur selon l'invention. A la différence de la cellule représentée à la figure 2, le couplage entre deux cellules consécutives est inductif et se fait par une self de liaison $L_2$ et par un condensateur de capacité élevée (non représenté) pour empêcher le passage du courant continu.

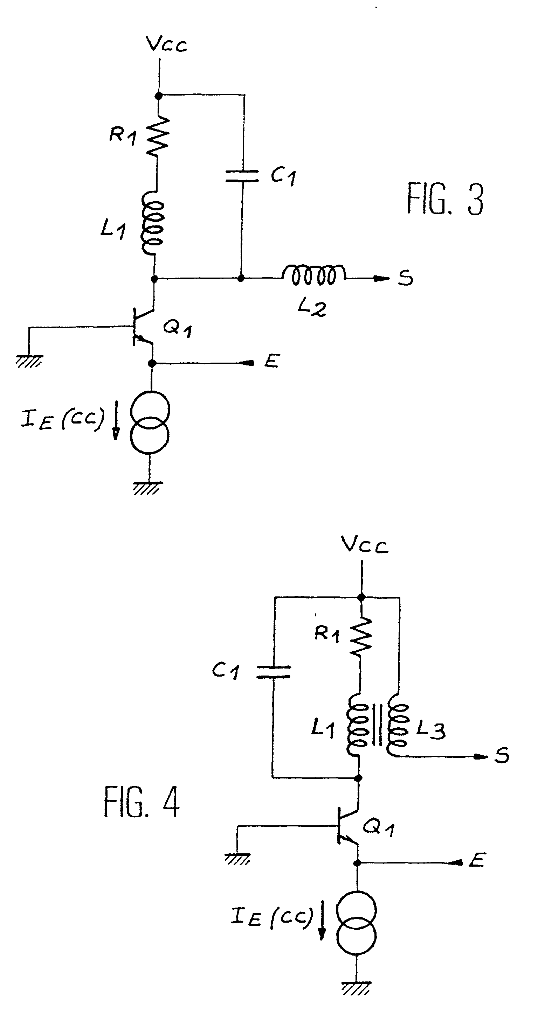

Pour la cellule représentée à la figure 4, le couplage entre deux cellules consécutives est également inductif. Il est réalisé par le secondaire $L_3$ d'un transformateur dont le primaire constitue l'inductance $L_1$ du circuit résonnant parallèle. Comme précédemment, un condensateur de capacité élevée (non représenté) empêche le passage du courant continu.

L'invention permet donc la réalisation d'un oscillateur en quadrature de bonne qualité quant au bruit de phase. Sa réalisation est simple et il présente un gain de consommation important par rapport à un oscillateur correspondant de l'art connu.

**Revendications**

1.   Oscillateur constitué de quatre cellules identiques déphasant de 90 degrés, le signal de sortie d'une cellule étant délivré à l'entrée de la cellule suivante et la sortie de la quatrième cellule étant reliée à l'entrée de la première cellule, chaque cellule comportant un amplificateur de courant ($Q_1$) et un circuit résonnant parallèle inductance-capacité ($L_1$, $C_1$, $C_2$) disposé de sorte que le courant de sortie d'une cellule soit une fraction du courant capacitif du circuit résonnant parallèle, assurant ainsi le déphasage de 90° entre les courants d'entrée et de sortie de la cellule.

2.   Oscillateur selon la revendication 1, **caractérisé en ce que** l'amplificateur de courant est constitué par un transistor ($Q_1$) monté en base commune, le circuit résonnant parallèle étant disposé dans le circuit du collecteur du transistor ($Q_1$).

3.   Oscillateur selon l'une des revendications 1 ou 2, **caractérisé en ce que** le couplage entre une cellule et la cellule suivante est un couplage capacitif.

4.   Oscillateur selon l'une des revendications 1 ou 2, **caractérisé en ce que** le couplage entre une cellule et la cellule suivante est un couplage inductif.

5.   Oscillateur selon la revendication 4, **caractérisé en ce que** le couplage inductif est réalisé par une self de liaison ($L_2$).

6.   Oscillateur selon la revendication 4, **caractérisé en ce que** le couplage inductif est réalisé par le secondaire ($L_3$) d'un transformateur dont le primaire constitue l'inductance ($L_1$) dudit circuit résonnant.

**Claims**

1.   Oscillator composed of four identical cells producing a phase shift of 90 degrees, the output signal from one cell being applied to the input of the next cell, the output of the fourth cell being connected to the input of the first cell, each cell comprising a current amplifier ($Q_1$) and a parallel inductance-capacitance resonant circuit ($L_1$, $C_1$, $C_2$) designed such that the output current from one cell is a fraction of the capacitive current of the parallel resonant circuit, thus creating the 90° phase shift between the cell input and output currents.

2.   Oscillator according to claim 1, **characterized in that** the current amplifier consists of a transistor ($Q_1$) mounted in common base, the parallel resonant circuit being located in the collector circuit of the transistor ($Q_1$).

3.   Oscillator according to either of claims 1 and 2, **characterized in that** the coupling between one cell and the next cell is capacitive.

4.   Oscillator according to either of claims 1 and 2, **characterized in that** the coupling between one cell and the next cell is inductive.

5.   Oscillator according to claim 4, **characterized in that** the inductive coupling is made using a connecting inductance ($L_2$).

6.   Oscillator according to claim 4, **characterized in that** inductive coupling is made by the secondary ($L_3$) of a transformer, the primary of the transformer forming the inductance ($L_1$) of the said resonant circuit.

**Patentansprüche**

1. Oszillator, umfassend vier identische, um 90° phasenverschobene Zellen, wobei das Ausgangssignal einer Zelle dem Eingang der nächsten Zelle geliefert wird und der Ausgang der vierten Zelle mit dem Eingang der ersten Zelle verbunden ist, und wobei jede Zelle einen Stromverstärker ($Q_1$) und einen parallelen Induktivität-Kapazität-Resonanzkreis ($L_1$, $C_1$, $C_2$) aufweist, der derart angeordnet ist, daß der Ausgangsstrom einer Zelle ein Bruchteil des kapazitiven Stroms des parallelen Resonanzkreises ist, wodurch die Phasenverschiebung um 90° zwischen dem Eingangs- und dem Ausgangsstrom der Zelle sichergestellt wird.

2. Oszillator nach Anspruch 1, **dadurch gekennzeichnet, daß** der Stromverstärker aus einem in Basisschaltung angebrachten Transistor ($Q_1$) besteht, wobei der parallele Resonanzkreis im Kollektor-Schaltkreis des Transistors ($Q_1$) angeordnet ist.

3. Oszillator nach einem der Ansprüche 1 oder 2, **dadurch gekennzeichnet, daß** die Kopplung zwischen einer Zelle und der nächsten Zelle eine kapazitive Kopplung ist.

4. Oszillator nach einem der Ansprüche 1 oder 2, **dadurch gekennzeichnet, daß** die Kopplung zwischen einer Zelle und der nächsten Zelle eine induktive Kopplung ist.

5. Oszillator nach Anspruch 4, **dadurch gekennzeichnet, daß** die induktive Kopplung durch eine Verbindungsdrossel ($L_2$) hergestellt ist.

6. Oszillator nach Anspruch 4, **dadurch gekennzeichnet, daß** die induktive Kopplung durch den Sekundärkreis ($L_3$) eines Transformators realisiert ist, dessen Primärkreis die Induktivität ($L_1$) des Resonanzkreises bildet.

FIG. 1

FIG. 2

FIG. 3

FIG. 4